# EUROPEAN PATENT APPLICATION

(11) **EP 4 694 659 A1**
(43) Date of publication of application: **11.02.2026**
(21) Application number: 25186901.2
(22) Date of filing: 02.07.2025
(51) Int. Cl.: H10N 60/01, H10N 60/80, H10N 69/00

(54) **METHOD OF MANUFACTURING QUANTUM DEVICE AND QUANTUM DEVICE**

(30) Priority: 09.08.2024 JP 2024134038
(71) Applicant: Fujitsu Limited, Kawasaki-shi, Kanagawa 211-8588 (JP)
(72) Inventor: HIROSE, Shinichi, Kawasaki-shi, 211-8588 (JP); KOUMA, Norinao, Kawasaki-shi, 211-8588 (JP); KAWANO, Hiroyasu, Kawasaki-shi, 211-8588 (JP)
(74) Representative: Haseltine Lake Kempner LLP

(57) **Abstract**

Provided is a method of manufacturing a quantum device (100) including a qubit and a qubit substrate (10) having a first surface (11) on which the qubit is formed. The method includes forming a first groove (60) in a second surface (12) of the qubit substrate, forming a first conductive film (22) on a bottom surface (61) and a side surface (62) of the first groove, forming a second groove (50) reaching a part of the bottom surface of the first groove in the first surface after the forming the first conductive film, forming a second conductive film (21) on a bottom surface (51) and a side surface (52) of the second groove; and forming the qubit on the first surface.

## Description

### FIELD

A certain aspect of the present embodiments relates to a method of manufacturing a quantum device and a quantum device.

### BACKGROUND

In a quantum device, there has been known a structure in which a conductive film is formed in a through hole provided from an upper surface to a lower surface of a substrate to electrically connect the upper surface and the lower surface (for example, J. A. Alfaro-Barrantes et al., "Highly-Conformal Sputtered Through-Silicon Vias With Sharp Superconducting Transition", JOURNAL OF MICROELECTRONECHANICAL SYSTEMS, VOL. 30, NO. 2, April 2021, pp. 253 - 261). There has been also known a structure in which the upper surface and the lower surface are electrically connected by forming a conductive film on the inner surface of a groove provided in each of the upper surface and the lower surface of the substrate (for example, Japanese Patent Application Publication No. 2008- 85020, and Japanese National Publication of International Patent Application No. 2008-532319). Further, there has been known a structure in which a conductive film is formed in a groove provided in one surface of a substrate, and the conductive film and a metal film provided in the other surface of the substrate are capacitively coupled (for example, Japanese Patent Application Publication No. 2022- 32990, and U.S. Patent Application Publication No. 2019/0165237).

### SUMMARY

**In** a quantum device, it is desired to provide a configuration in which a first surface on which a qubit is provided and a second surface are electrically connected by a conductive film provided over the first surface to the second surface of a qubit substrate. **In** this case, it is conceivable to form a through hole penetrating from the first surface to the second surface and having a vertical side surface, and then to form a conductive film on the side surface of the through hole from the first surface side and the second surface side, and electrically connect the first surface and the second surface by the conductive film. However, the conductive film formed from a first surface side and the conductive film formed from a second surface side have thin film thicknesses near the center of the through hole, which causes a problem in terms of electrical connection of the conductive films.

**In** order to suppress the film thickness from becoming thin in the vicinity of the center of the through hole, it is conceivable to incline the side surface of the through hole in a tapered shape from the first surface and the second surface toward the center of the through hole. However, in this case, since the contact area between the conductive film formed from the first surface side and the conductive film formed from the second surface side is reduced, there is room for improvement in terms of the electrical connection of the conductive film.

**In** order to improve the reliability of electrical connection, a first groove is formed in a first surface of the qubit substrate, and a first conductive film is formed on the inner surface of the first groove. It is conceivable to form a second groove reaching the first groove on the second surface and to form a second conductive film connected to the first conductive film on the inner surface of the second groove. This allows the first conductive film and the second conductive film to be connected to each other at the bottom surfaces of the first and second grooves, thereby improving the reliability of the electrical connection. However, in this case, the mechanical strength of the first conductive film and the second conductive film may be decreased.

**In** one aspect, the object is to suppress a decrease in mechanical strength of the first conductive film and the second conductive film while maintaining electrical connection.

According to an aspect of the present disclosure, there is provided a method of manufacturing a quantum device including a qubit and a qubit substrate having a first surface on which the qubit is formed, the method including: forming a first groove in a second surface of the qubit substrate; forming a first conductive film on a bottom surface and a side surface of the first groove; forming a second groove reaching a part of the bottom surface of the first groove in the first surface after the forming the first conductive film; forming a second conductive film on a bottom surface and a side surface of the second groove; and forming the qubit on the first surface.

### BRIEF DESCRIPTION OF THE DRAWINGS

FIG. 1 is a plan view of a quantum device according to a first embodiment.
FIG. 2A is a cross-sectional view of the quantum device according to the first embodiment, and FIG. 2B is an enlarged view of the vicinity of a first groove and a second groove in FIG. 2A.
FIG. 3A is a plan view of a Josephson element according to the first embodiment, and FIGs. 3B and 3C are cross-sectional views taken along a line A-A and a line B-B of FIG. 3A.
FIGs. 4A to 4C are cross-sectional views (Part 1) illustrating a method of manufacturing the quantum device according to the first embodiment.
FIGs. 5A to 5C are cross-sectional views (Part 2) illustrating a method of manufacturing the quantum device according to the first embodiment.
FIGs. 6A to 6C are third cross-sectional views (Part 3) illustrating a method of manufacturing the quantum device according to the first embodiment.
FIGs. 7A to 7I are views (Part 1) illustrating a method of manufacturing a Josephson element according to the first embodiment.
FIGs. 8A to 8F are views (Part 2) illustrating a method of manufacturing the Josephson device according to the first embodiment.
FIG. 9A is a plan view illustrating a connecting portion between the first groove and the second groove in the first embodiment, and FIG. 9B is a plan view illustrating a contact portion between the first conductive film and the second conductive film in the first embodiment.
FIGs. 10A to 10C are cross-sectional views (Part 1) illustrating a method of manufacturing a quantum device according to a comparative example.
FIGs. 11A and 11B are cross-sectional views (Part 2) illustrating a method of manufacturing the quantum device according to the comparative example.
FIGs. 12A to 12C are cross-sectional views (Part 1) illustrating a method of manufacturing a quantum device according to a second embodiment.
FIGs. 13A and 13B are cross-sectional views (Part 2) illustrating a method of manufacturing the quantum device according to the second embodiment.

### EFFECT

As one aspect, it is possible to suppress a decrease in mechanical strength of the first conductive film and the second conductive film while maintaining electrical connection.

### DETAILED DESCRIPTION

Hereinafter, embodiments of the present disclosure will be described with reference to the drawings.

### [First embodiment]

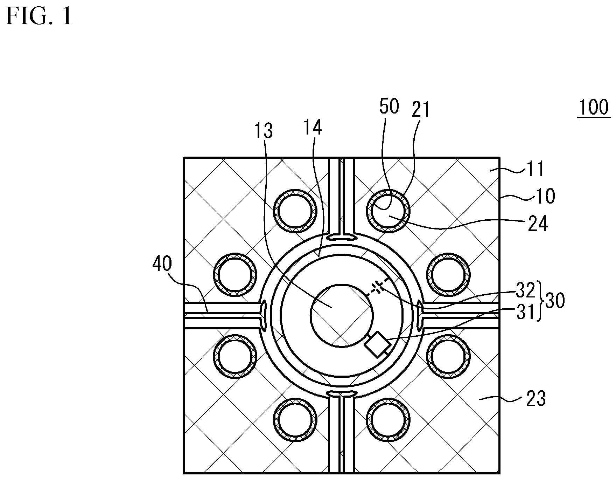

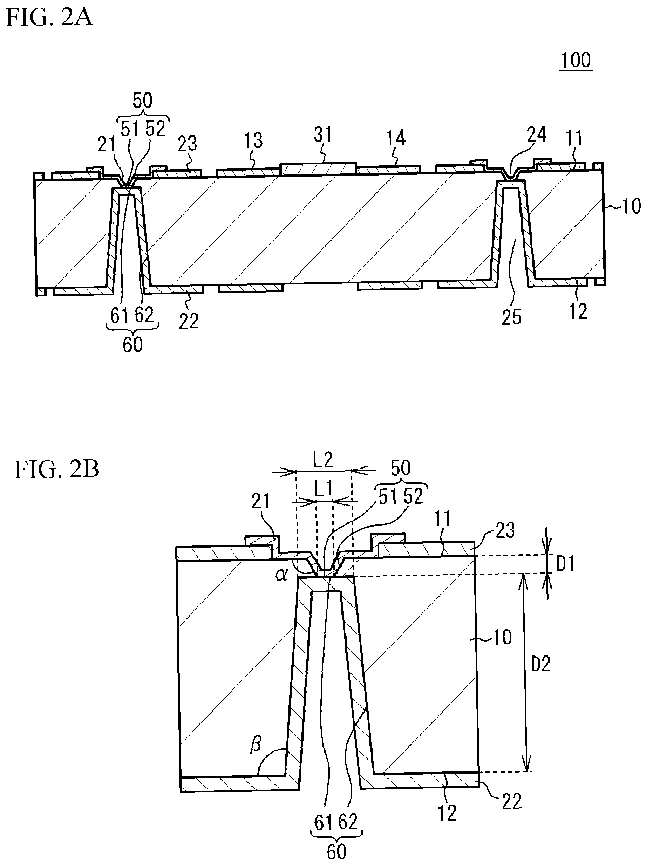

FIG. 1 is a plan view of a quantum device 100 according to a first embodiment. FIG. 2A is a cross-sectional view of the quantum device 100 according to the first embodiment, and FIG. 2B is an enlarged view of the vicinity of a first groove 50 and a second groove 60 in FIG. 2A. In FIG. 1, a first conductive film 21 and a third conductive film 23 are hatched for the sake of clarity.

As illustrated in FIG. 1, a qubit 30 and a coupling wiring 40 are provided on an upper surface 11 of a qubit substrate 10 which is, for example, a silicon (Si) substrate. The quantum device 100 is used in a quantum computer and operates in a superconducting state at a very low temperature of, for example, several tens of millikelvin (mK). The qubit 30 is an element that form a coherent two level system by using superconductivity. The qubit 30 includes a Josephson element 31 connected between a central electrode 13 and a peripheral electrode 14, and a capacitor 32 formed by the central electrode 13 and the peripheral electrode 14 facing each other. That is, the qubit 30 includes a Transmon qubit circuit in which the Josephson element 31 and the capacitor 32 are connected in parallel. The coupling wiring 40 is electrostatically coupled to the qubits 30 to couple between adjacent qubits 30. Thus, each of the qubits 30 performs a quantum operation by generating a quantum entangled state with the other adjacent qubit 30.

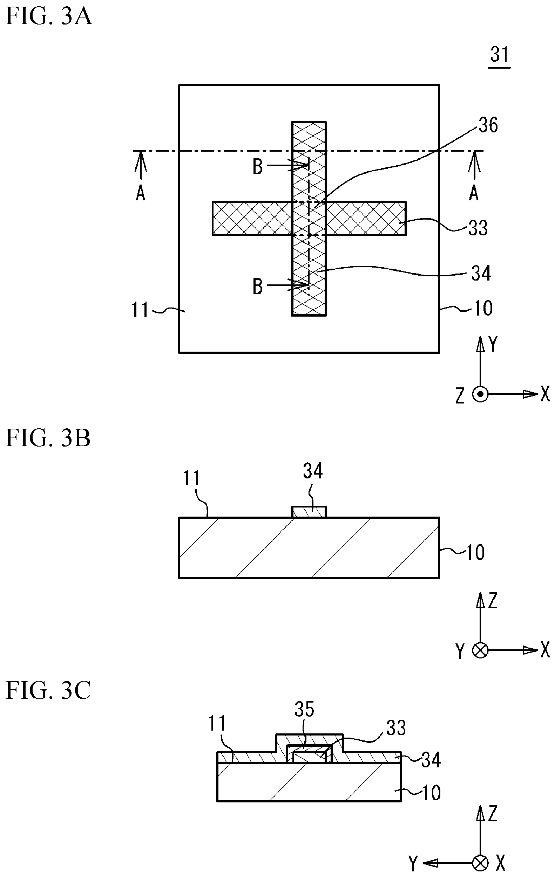

FIG. 3A is a plan view of the Josephson element 31 in the first embodiment, FIG. 3B is a cross-sectional view taken along a line A-A in FIG. 3A, and FIG. 3C is a cross-sectional view taken along a line B-B in FIG. 3A. In FIGs. 3A to 3C, directions parallel to the upper surface 11 of the qubit substrate 10 and orthogonal to each other are defined as an X-axis direction and a Y-axis direction, and a normal direction of the upper surface 11 is defined as a Z-axis direction. In FIG. 3A, an insulating film 35 provided on the surface of a superconducting film 33 is not illustrated.

As illustrated in FIGs. 3A to 3C, the Josephson element 31 includes the superconducting film 33 extending in the X-axis direction, a superconducting film 34 extending in the Y-axis direction, and the insulating film 35 provided between the superconducting film 33 and the superconducting film 34 in a region where the superconducting film 33 and the superconducting film 34 overlap each other. The region where the superconducting film 33 and the superconducting film 34 overlap with the insulating film 35 therebetween is a Josephson junction 36.

The superconducting films 33 and 34 are formed of a superconducting material that exhibits superconductivity at a temperature equal to or lower than a predetermined critical temperature. The insulating film 35 is provided to cover the surface of the superconducting film 33, for example. The superconducting films 33 and 34 are, for example, aluminum (Al) films. The insulating film 35 is, for example, an aluminum oxide (Al₂O₃) film. One of the superconducting films 33 and 34 is connected to the central electrode 13, and the other is connected to the peripheral electrode 14, so that the Josephson element 31 is connected between the central electrode 13 and the peripheral electrode 14.

As illustrated in FIGs. 1, 2A and 2B, the third conductive film 23 is provided on the upper surface 11 of the qubit substrate 10. The third conductive film 23 is patterned to form the central electrode 13, the peripheral electrode 14, and the coupling wiring 40. The third conductive film 23 is connected to, for example, a ground except for the central electrode 13, the peripheral electrode 14, and the coupling wiring 40. The third conductive film 23 is formed of a superconducting material that exhibits superconductivity at a temperature equal to or lower than a predetermined critical temperature, and is, for example, a titanium nitride (TiN) film. First grooves 50 are provided in the upper surface 11 of the qubit substrate 10. Second grooves 60 are provided in a lower surface 12 of the qubit substrate 10. The first groove 50 and the second groove 60 constitute a through via. The through via serves as a read electrode for fixing the ground potential and reading a signal from the qubit 30 by taking electrical conduction between the upper surface 11 and the lower surface 12.

The first groove 50 is provided so as to overlap the second groove 60 in plan view, and is connected to only a part of a bottom surface 61 of the second groove 60. Accordingly, a diameter L1 of a bottom surface 51 of the first groove 50 is smaller than a diameter L2 of the bottom surface 61 of the second groove 60. For example, the diameter L1 is equal to or more than 1/5 of the diameter L2, and equal to or less than 1/2 of the diameter L2. A depth D1 of the first groove 50 is smaller than a depth D2 of the second groove 60. For example, the depth D1 is equal to or less than 1/10 of the depth D2.

A side surface 52 of the first groove 50 and a side surface 62 of the second groove 60 are both inclined in a tapered shape. That is, a first angle α formed by the side surface 52 of the first groove 50 and the upper surface 11 of the qubit substrate 10 and a second angle β formed by the side surface 62 of the second groove 60 and the lower surface 12 of the qubit substrate 10 are both obtuse angles. The first angle α is greater than the second angle β. Accordingly, the side surface 52 of the first groove 50 is inclined more gently than the side surface 62 of the second groove 60.

The first conductive film 21 is provided on the bottom surface 51 and the side surface 52 of the first groove 50. The first conductive film 21 is provided from the side surface 52 of the first groove 50 to the third conductive film 23, and is in contact with the upper surface of the third conductive film 23. The first groove 50 has a cavity 24 inside the first conductive film 21. The first conductive film 21 is formed of a superconducting material that exhibits superconductivity at a temperature equal to or lower than a predetermined critical temperature, and is, for example, a titanium nitride (TiN) film.

A second conductive film 22 is provided on the bottom surface 61 and the side surface 62 of the second groove 60. The second conductive film 22 is provided from the side surface 62 of the second groove 60 to the lower surface 12 of the qubit substrate 10. The second groove 60 has a cavity 25 inside the second conductive film 22. The second conductive film 22 is formed of a superconducting material that exhibits superconductivity at a temperature equal to or lower than a predetermined critical temperature, and is, for example, a titanium nitride (TiN) film.

The first conductive film 21 and the second conductive film 22 are in contact with each other at a portion where the first groove 50 and the second groove 60 are connected. That is, the first conductive film 21 and the second conductive film 22 are in contact with each other at their surfaces. The first conductive film 21 and the second conductive film 22 are connected to, for example, a ground. The bottom surface 51 of the first groove 50 is flush with the bottom surface 61 of the second groove 60. Therefore, the plane of the first conductive film 21 closest to the second groove 60 and the plane of the second conductive film 22 closest to the first groove 50 are flush with each other.

The qubit substrate 10 may be a semiconductor substrate or an insulating substrate other than a silicon substrate, or may be, for example, a sapphire substrate. The first conductive film 21, the second conductive film 22, and the third conductive film 23 may be formed of a superconducting material other than titanium nitride, and may be formed of, for example, an aluminum (Al) film, a niobium (Nb) film, or a tantalum (Ta) film.

### [Manufacturing Method]

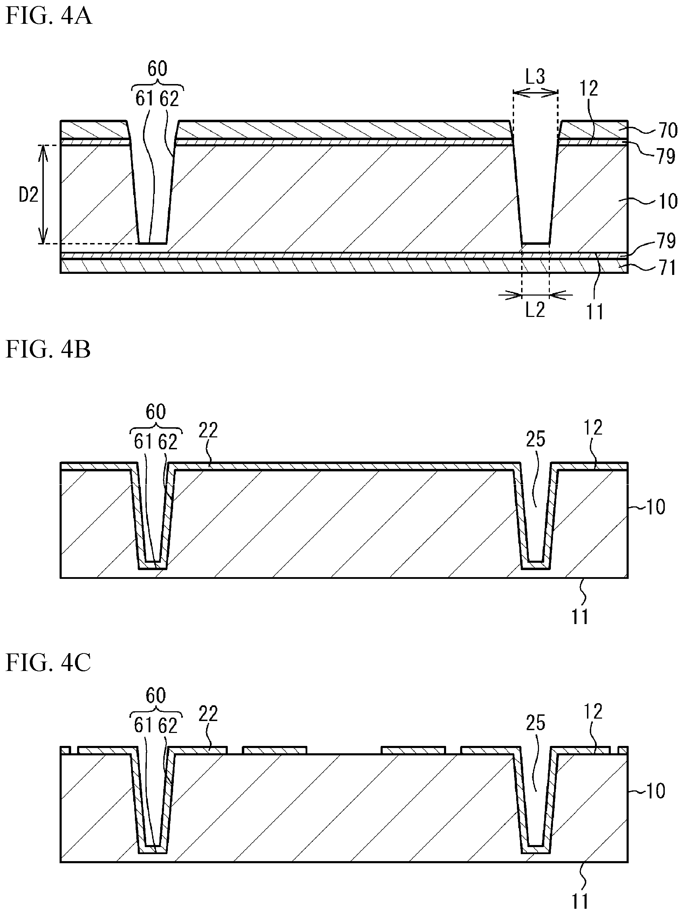

FIGs. 4A to 6C are cross-sectional views illustrating a method of manufacturing the quantum device 100 according to the first embodiment. As illustrated in FIG. 4A, metal films 79 such as aluminum films are formed on the lower surface 12 (an upper surface in FIG. 4A) and the upper surface 11 (a lower surface in FIG. 4A) of the qubit substrate 10 which is, for example, a silicon substrate. Next, a patterned resist film 70 is formed on the lower surface 12 of the qubit substrate 10. A protective resist film 71 is formed on the upper surface 11 of the qubit substrate 10. The second groove 60 having the bottom surface 61 and the side surface 62 is formed in the lower surface 12 of the qubit substrate 10 by using the resist film 70 as a mask. The second groove 60 is formed by dry etching, for example, reactive ion etching using a Bosch process. The etching of the qubit substrate 10 using, for example, SF₆ gas and the formation of a protective film using C₄F₈ gas are alternately repeated to form the second groove 60. The depth D2 of the second groove 60 may be, for example, greater than 1/2 or greater than 3/4 of the distance between the upper surface 11 and the lower surface 12 of the qubit substrate 10 (that is, the thickness of the qubit substrate 10). As an example, when the thickness of the qubit substrate 10 is 300 µm, the depth D2 is 250 µm or more and 290 µm or less. The diameter L2 of the second groove 60 at the lower surface 61 is, for example, 70 µm or more and 80 µm or less, and a diameter L3 at the lower surface 12 is, for example, 140 µm or more and 160 µm or less.

As illustrated in FIG. 4B, after the resist films 70 and 71 and the metal film 79 are removed, the second conductive film 22 which is, for example, a titanium nitride film is formed on the lower surface 12 of the qubit substrate 10 and the bottom surface 61 and the side surface 62 of the second groove 60. The scallops (i.e., unevennesses) generated on the side surfaces 62 of the second grooves 60 may be removed before and after the removal of the metal film 79. The second conductive film 22 is formed by, for example, an atomic layer deposition (ALD) method. By using the ALD method, even when the depth D2 is large, variations in the thickness of the second conductive film 22 formed on the bottom surface 61 and the side surface 62 of the second groove 60 can be suppressed. In the second groove 60, the cavity 25 is formed inside the second conductive film 22. The thickness of the second conductive film 22 is, for example, 50 nm or more and 500 nm or less.

As illustrated in FIG. 4C, the second conductive film 22 is patterned by a photolithography method and an etching method. The etching is reactive ion etching using, for example, CF₄ gas.

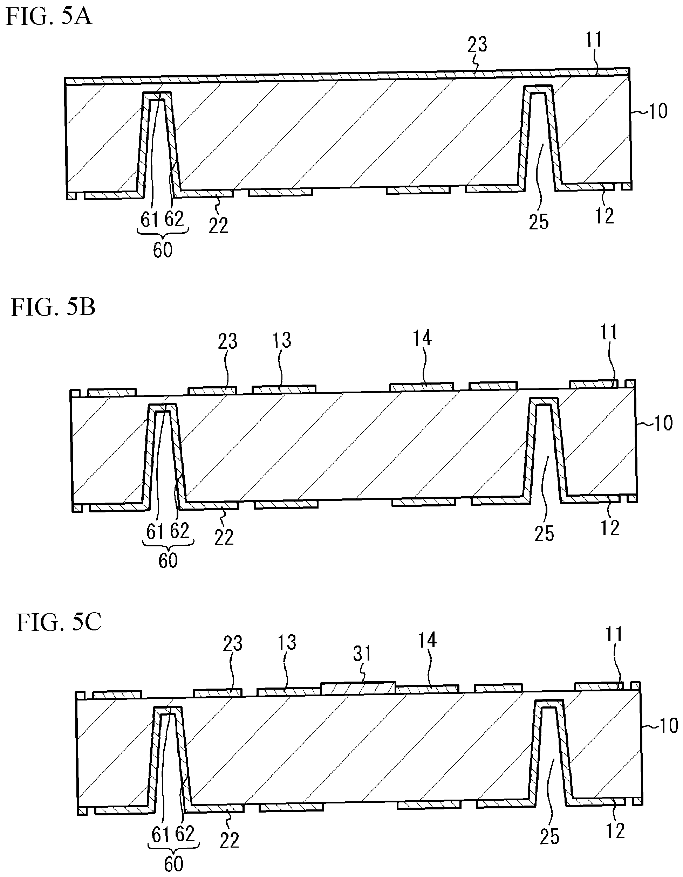

As illustrated in FIG. 5A, the third conductive film 23 which is, for example, a titanium nitride film is formed on the upper surface 11 of the qubit substrate 10 by, for example, a sputtering method. The thickness of the third conductive film 23 is, for example, 50 nm or more and 500 nm or less.

As illustrated in FIG. 5B, the third conductive film 23 is patterned by the photolithography method and the etching method. The etching is reactive ion etching using, for example, CF₄ gas. The third conductive film 23 is patterned to form the central electrode 13, the peripheral electrode 14, and the coupling wiring 40 (see FIG. 1).

As illustrated in FIG. 5C, the Josephson element 31 is formed on the upper surface 11 of the qubit substrate 10, thereby forming the qubit 30 (see FIG. 1).

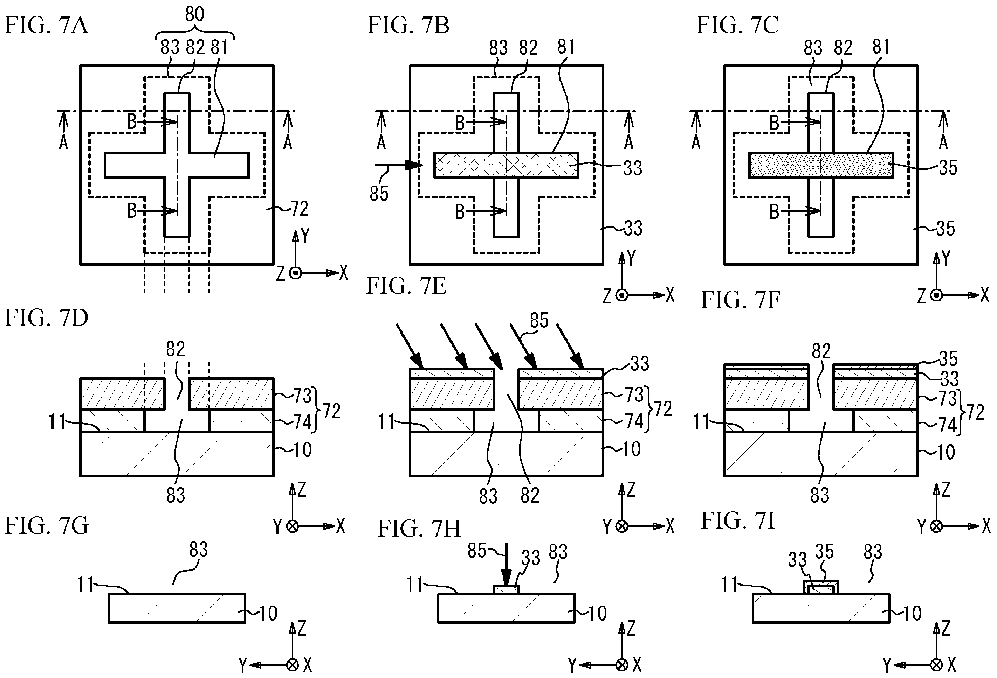

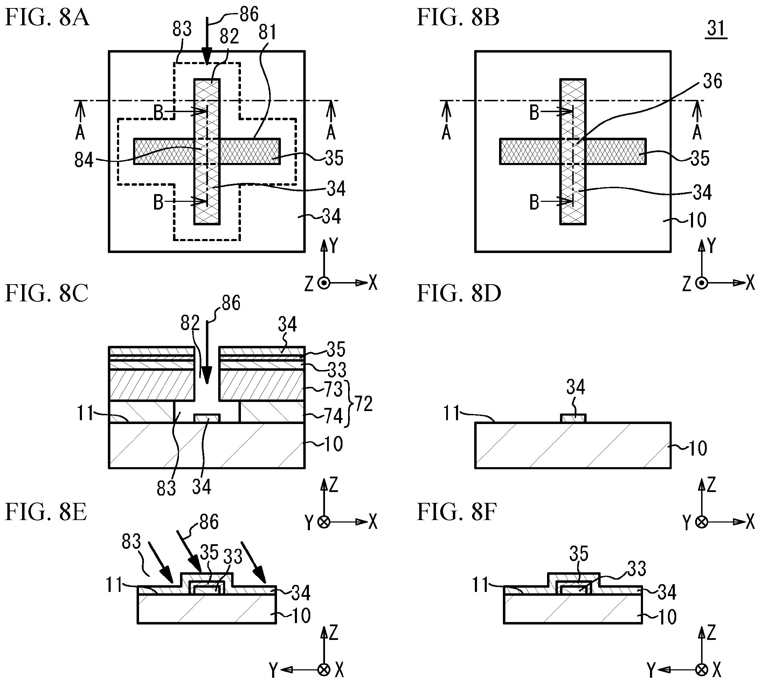

FIGs. 7A to 7I and 8A to 8F are views illustrating a method of manufacturing the Josephson element 31 according to the first embodiment. FIGs. 7A to 7C and 8A to 8B are plan views illustrating a method of manufacturing the Josephson element 31. FIGs. 7D to 7F and 8C to 8D are cross-sectional views taken along the line A-A of FIGs. 7A to 7C and 8A to 8B, respectively. FIGs. 7G to 7I and 8E to 8F are cross-sectional views taken along the line B-B of FIGs. 7A to 7C and 8A to 8B, respectively. In FIGs. 7A to 7I and 8A to 8F, the X-axis direction, the Y-axis direction, and the Z-axis direction are also illustrated as in FIGs. 3A to 3C. In FIGs. 7A to 7C and 8A to 8B, the superconducting film 33, the superconducting film 34, and the insulating film 35 formed in the cavity 83 are hatched for the sake of clarity of the drawings.

As illustrated in FIGs. 7A, 7D and 7G, a patterned laminated resist film 72 is formed on the upper surface 11 of the qubit substrate 10. The laminated resist film 72 has an upper layer 73 and a lower layer 74. A pattern 80 including an opening 81, an opening 82, and a cavity 83 is formed in the laminated resist film 72. The opening 81 extends in the X-axis direction, and the opening 82 intersects the opening 81 and extends in the Y-axis direction. Both of the openings 81 and 82 are formed in the upper layer 73. The cavity 83 is formed in the lower layer 74. The cavity 83 is located below the openings 81 and 82 and has a shape that is larger than the openings 81 and 82 in plan view. The widths of the openings 81 and 82 are, for example, 100 nm to 300 nm.

As illustrated in FIGs. 7B, 7E and 7H, the superconducting film 33 is formed on the upper surface 11 of the qubit substrate 10 by an oblique vacuum deposition method from above in the - X direction as illustrated by arrows 85 by using the laminated resist film 72 as a mask. Since the superconducting film 33 is formed by the oblique vacuum deposition method from above in the -X direction, only the superconducting film 33 extending in the X-axis direction is formed in the cavity 83 by setting the width dimension of the opening 82 to an appropriate size. The superconducting film 33 is, for example, an aluminum film, and has a thickness of, for example, 30 nm to 50 nm and a width of, for example, 100 nm to 300 nm.

As illustrated in FIGs. 7C, 7F and 7I, oxygen is introduced into a chamber to oxidize the surface of the superconducting film 33 while maintaining the vacuum state at the time of forming the superconducting film 33, and the insulating film 35 made of, for example, aluminum oxide is formed on the surface of the superconducting film 33.

As illustrated in FIGs. 8A, 8C and 8E, the superconducting film 34 is formed on the upper surface 11 of the qubit substrate 10 by the oblique vacuum deposition method from above in the +Y direction as illustrated by arrows 86 by using the laminated resist film 72 as a mask. Since the superconducting film 34 is formed by the oblique vacuum deposition method from above in the +Y direction, only the superconducting film 34 extending in the Y axis direction is formed in the cavity 83 by setting the width dimension of the opening 81 to an appropriate size. The superconducting film 34 is, for example, an aluminum film, and has a thickness of, for example, 50 nm to 70 nm and a width of, for example, 100 nm to 300 nm. As a result, a region 84 is formed where the superconducting film 33 extending in the X-axis direction and the superconducting film 34 extending in the Y-axis direction overlap with the insulating film 35 therebetween.

As illustrated in FIGs. 8B, 8D and 8F, the laminated resist film 72, and the superconducting film 33, the insulating film 35 and the superconducting film 34 formed on the laminated resist film 72 are removed by a lift-off method. The region 84 where the superconducting film 33 extending in the X-axis direction and the superconducting film 34 extending in the Y-axis direction overlap with the insulating film 35 therebetween is the Josephson junction 36.

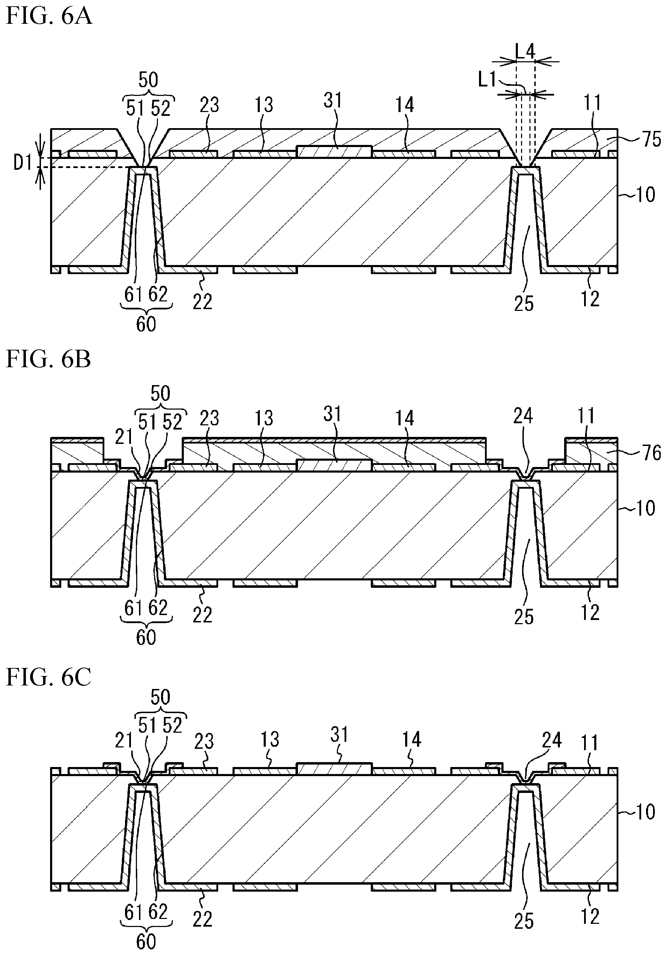

As illustrated in FIG. 6A, a patterned resist film 75 is formed on the upper surface 11 of the qubit substrate 10. The first groove 50 having the bottom surface 51 and the side surface 52 is formed in the upper surface 11 of the qubit substrate 10 by using the resist film 75 as a mask. The first groove 50 is formed by dry etching, for example, reactive ion etching. For example, the first groove 50 is formed by etching the qubit substrate 10 using CF₄ gas and O₂ gas. The first groove 50 is formed so as to reach only a part of the bottom surface 61 of the second groove 60. As a result, a part of the second conductive film 22 formed on the bottom surface 61 of the second groove 60 is exposed from the bottom surface 51 of the first groove 50. In the formation of the first groove 50, the second conductive film 22 can be used as an etching stopper layer. The depth D1 of the first groove 50 is, for example, less than 1/2 of the distance between the upper surface 11 and the lower surface 12 of the qubit substrate 10, and may be less than 1/4 of the distance between the upper surface 11 and the lower surface 12 of the qubit substrate 10. As an example, when the thickness of the qubit substrate 10 is 300 µm, the depth D1 is 10 µm or more and 50 µm or less. The diameter L1 of the first groove 50 at the bottom surface 51 is, for example, 40 µm or more and 60 µm or less, and a diameter L4 of the first groove 50 at the upper surface 11 is, for example, 140 µm or more and 160 µm or less.

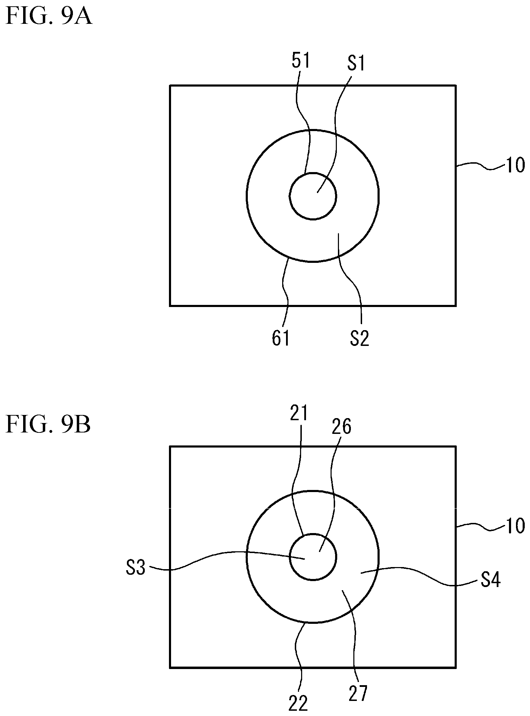

FIG. 9A is a plan view illustrating a connecting portion between the first groove 50 and the second groove 60 in the first embodiment. Since the first groove 50 is formed so as to reach only a part of the second groove 60, an area S1 of the bottom surface 51 of the first groove 50 is smaller than an area S2 of the bottom surface 61 of the second groove 60 as illustrated in FIG. 9A. For example, the area S1 of the bottom surface 51 of the first groove 50 is 1/25 times or more and 1/4 times or less the area S2 of the bottom surface 61 of the second groove 60.

As illustrated in FIG. 6B, after the resist film 75 is removed, a patterned resist film 76 is formed on the upper surface 11 of the qubit substrate 10. The first conductive film 21 which is, for example, a titanium nitride film is formed by, for example, a vacuum deposition method by using the resist film 76 as a mask. The first conductive film 21 is formed from the bottom surface 51 and the side surface 52 of the first groove 50 to the upper surface of the third conductive film 23, and is in contact with the third conductive film 23. In the first groove 50, the cavity 24 is formed inside the first conductive film 21. The thickness of the first conductive film 21 is 50 nm or more and 500 nm or less.

FIG. 9B is a plan view illustrating a contact portion between the first conductive film 21 and the second conductive film 22 in the first embodiment. As illustrated in FIG. 9B, the first conductive film 21 and the second conductive film 22 are brought into contact with each other at their surfaces. Therefore, the reliability of the electrical connection between the first conductive film 21 and the second conductive film 22 is improved. An area S3 of a flat surface 26, which is the surface of the first conductive film 21 closest to the second groove 60 and in contact with the second conductive film 22, is smaller than an area S4 of a flat surface 27 which is the surface of the second conductive film 22 closest to the first groove 50 and in contact with the first conductive film 21. For example, the area S3 of the flat surface 26 of the first conductive film 21 is 1/25 times or more and 1/4 times or less the area S4 of the flat surface 27 of the second conductive film 22.

As illustrated in FIG. 6C, the resist film 76 and the first conductive film 21 formed on the resist film 76 are removed by the lift-off method. The quantum device 100 according to the first embodiment is thus formed.

### [Comparative Example]

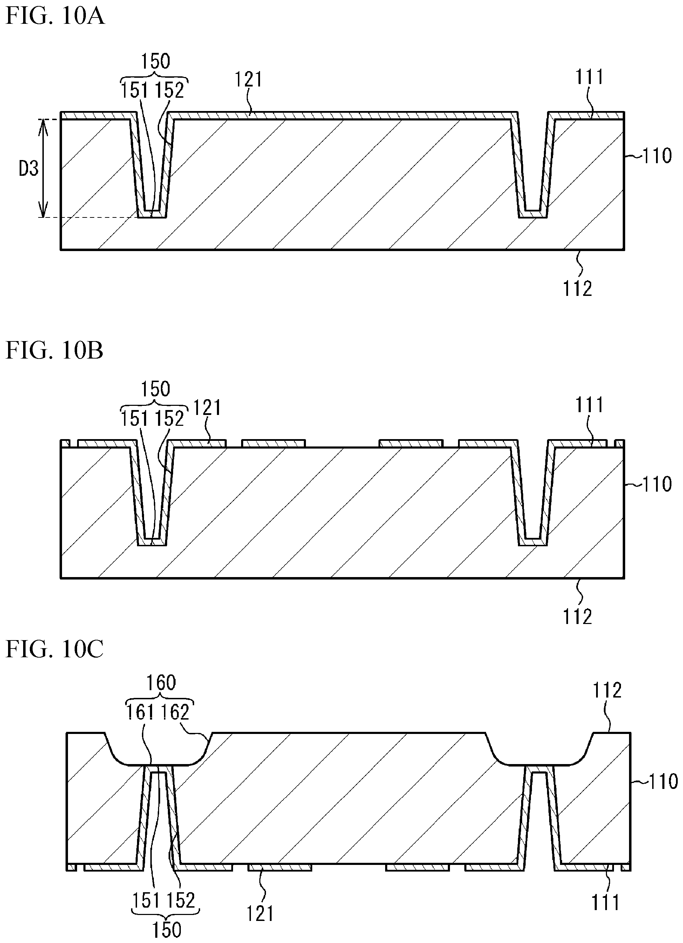

FIGs. 10A to 11B are cross-sectional views illustrating a method of manufacturing a quantum device according to a comparative example. As illustrated in FIG. 10A, a groove 150 having a bottom surface 151 and a side surface 152 is formed in the upper surface 111 of a qubit substrate 110 by the photolithography method and the etching method. The groove 150 is formed by reactive ion etching using, for example, the Bosch process. For example, when the thickness of the qubit substrate 110 is 300 µm, the depth D3 of the groove 150 is 200 µm or more and 250 µm or less. Then, a conductive film 121 is formed on the upper surface 111 of the qubit substrate 110 and the bottom surface 151 and the side surface 152 of the groove 150. The conductive film 121 is formed by, for example, the ALD method.
The thickness of the conductive film 121 is, for example, 50 nm or more and 500 nm or less.

As illustrated in FIG. 10B, the conductive film 121 is patterned by the photolithography method and the etching method.

As illustrated in FIG. 10C, a groove 160 having a bottom surface 161 and a side surface 162 is formed in a lower surface 112 (an upper surface in FIG. 10C) of the qubit substrate 110 by the photolithography method and the etching method. The groove 160 is formed such that the bottom surface 161 is larger than the bottom surface 151 of the groove 150. Therefore, the entire conductive film 121 provided on the bottom surface 151 of the groove 150 is exposed from the bottom surface 161 of the groove 160.

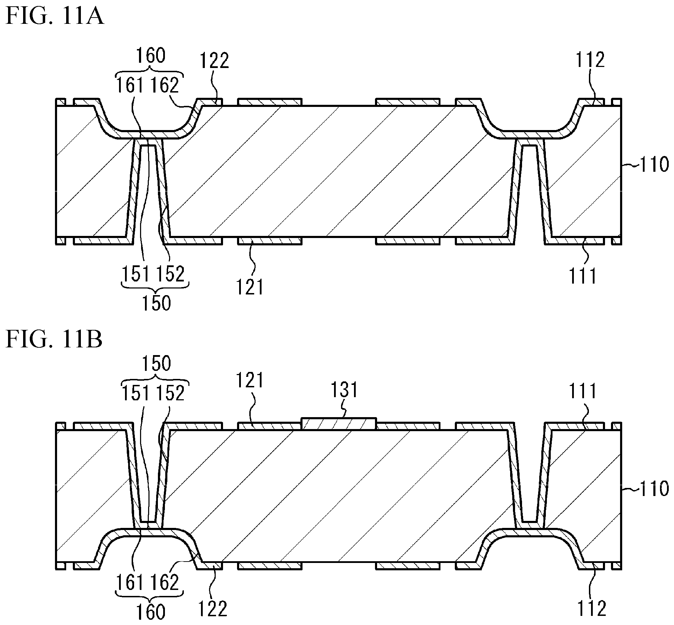

As illustrated in FIG. 11A, a conductive film 122 is formed on the lower surface 112 (an upper surface in FIG. 11A) of the qubit substrate 110 by, for example, the sputtering method. The thickness of the conductive film 122 is, for example, 50 nm or more and 500 nm or less. Thereafter, the conductive film 122 is patterned by the photolithography method and the etching method.

As illustrated in FIG. 11B, a Josephson element 131 is formed on the upper surface 111 of the qubit substrate 110. The Josephson element 131 is formed by the same method as the method of FIGs. 7A to 7I and 8A to 8F. As a result, the quantum device according to the comparative example is formed.

In the comparative example, as illustrated in FIG. 10C, the entire conductive film 121 provided on the bottom surface 151 of the groove 150 is exposed from the bottom surface 161 of the groove 160. Therefore, as illustrated in FIG. 11A, the contact area between the conductive film 121 and the conductive film 122 is increased, and the reliability of the electrical connection is improved. However, in FIG. 10C, the conductive film 121 provided on the bottom surface 151 of the groove 150 is not in contact with the qubit substrate 110 but is in a floating state. Since the thickness of the conductive film 121 is as thin as 50 nm or more and 500 nm or less, the conductive film 121 provided on the bottom surface 151 of the groove 150 has a low strength. Therefore, for example, when a physical external force is applied to the conductive film 121 during the manufacturing process, the conductive film is likely to be damaged. As illustrated in FIG. 11A, since the thickness of the conductive film 122 formed in the groove 160 is as thin as 50 nm to 500 nm, the conductive films 121 and 122 on the bottom surface 151 of the groove 150 have low strength even after the conductive film 122 is formed. Therefore, when a physical external force is applied to the conductive films 121 and 122 during and after the manufacturing process, for example, the conductive films are likely to be broken. As described above, in the comparative example, the mechanical strength of the conductive films 121 and 122 is low.

On the other hand, according to the first embodiment, as illustrated in FIG. 4A, the second groove 60 is formed in the lower surface 12 (second surface) of the qubit substrate 10. As illustrated in FIG. 4B, the second conductive film 22 is formed on the bottom surface 61 and the side surface 62 of the second groove 60. As illustrated in FIG. 6A, after the second conductive film 22 is formed, the first groove 50 reaching a part of the bottom surface 61 of the second groove 60 is formed in the upper surface 11 (first surface) of the qubit substrate 10. As illustrated in FIG. 6B, the first conductive film 21 is formed on the bottom surface 51 and the side surface 52 of the first groove 50. Since the first groove 50 is formed so as to reach a part of the bottom surface 61 of the second groove 60, the area where the second conductive film 22 is exposed from the bottom surface 51 of the first groove 50 is small as illustrated in FIG. 6A. A portion of the second conductive film 22 provided on the bottom surface 61 of the second groove 60, which is not exposed from the bottom surface 51 of the first groove 50, is in contact with the qubit substrate 10. Therefore, the second conductive film 22 is suppressed from being reduced in strength and is less likely to be damaged. As illustrated in FIG. 6B, even after the first conductive film 21 is formed, the areas of the first conductive film 21 and the second conductive film 22 which are not in contact with the qubit substrate 10 are small, and thus, a decrease in the strength of the first conductive film 21 and the second conductive film 22 is suppressed. Therefore, according to the first embodiment, it is possible to suppress a decrease in the mechanical strength of the first conductive film 21 and the second conductive film 22.

According to the first embodiment, as illustrated in FIGs. 1, 2A, and 2B, the qubit 30 is provided on the upper surface 11 (first surface) of the qubit substrate 10. The second groove 60 is provided in the lower surface 12 (second surface) of the qubit substrate 10. The second conductive film 22 is provided on the bottom surface 61 and the side surface 62 of the second groove 60. The first groove 50 reaching a part of the bottom surface 61 of the second groove 60 is provided in the upper surface 11 of the qubit substrate 10. The first conductive film 21 is provided on the bottom surface 51 and the side surface 52 of the first groove 50. With such a configuration, it is possible to suppress a decrease in the mechanical strength of the first conductive film 21 and the second conductive film 22.

In the first embodiment, as illustrated in FIGs. 4A and 6A, the second groove 60 having the depth D2 larger than the depth D1 of the first groove 50 is formed. This makes it possible to suppress the diameter L4 of the first groove 50 on the upper surface 11 of the qubit substrate 10 from increasing. Therefore, the formation region of the qubit 30 and the like can be secured without increasing the size of the qubit substrate 10.

From the viewpoint of suppressing an increase in the diameter L4, the depth D2 is preferably equal to or greater than 70%, more preferably equal to or greater than 80%, and still more preferably equal to or greater than 90% of the distance between the upper surface 11 and the lower surface 12. From the viewpoint of suppressing the penetration of the second groove 60 through the qubit substrate 10 due to manufacturing variations or the like, the depth D2 is preferably 95% or less, more preferably 90% or less, and still more preferably 85% or less of the distance between the upper surface 11 and the lower surface 12.

In addition, in the first embodiment, as illustrated in FIG. 2B, the second groove 60 is formed so that the second angle β between the side surface 62 of the second groove 60 and the lower surface 12 of the qubit substrate 10 is an obtuse angle. The first groove 50 is formed so that the first angle α formed by the side surface 52 of the first groove 50 and the upper surface 11 of the qubit substrate 10 is larger than the second angle β. When the second angle β is an obtuse angle, the second conductive film 22 having a desired thickness is likely to be formed on the side surface 62 of the second groove 60. In addition, since the second angle β is smaller than the first angle α, the diameter L3 (see FIG. 4A) of the second groove 60 on the lower surface 12 of the qubit substrate 10 is suppressed from increasing, and the qubit substrate 10 can be suppressed from increasing in size. When the first angle α is larger than the second angle β, the first conductive film 21 is likely to be formed to have a desired thickness on the bottom surface 51 and the side surface 52 of the first groove 50 even when the diameter L1 of the bottom surface 51 of the first groove 50 is small. The thickness of the first conductive film 21 and the second conductive film 22 may affect the occurrence of a phenomenon called superconducting transition, which is a transition to the superconducting state. However, according to the present embodiment, since each of the first conductive film 21 and the second conductive film 22 can be formed to have a desired thickness, it is possible to suppress variations in the read characteristics particularly when the first conductive film 21 and the second conductive film 22 are used as the read electrodes.

From the viewpoint of forming the second conductive film 22 with a desired thickness, the second angle β is preferably 95 degrees or more, more preferably 98 degrees or more, and still more preferably 100 degrees or more. From the viewpoint of suppressing an increase in the diameter L3, the second angle β is preferably 110 degrees or less, more preferably 107 degrees or less, and still more preferably 103 degrees or less. In addition, from the viewpoint of forming the first conductive film 21 with a desired thickness, the first angle α is preferably 130 degrees or more, more preferably 135 degrees or more, and still more preferably 140 degrees or more. From the viewpoint of suppressing an increase in the diameter L4 of the first groove 50 on the upper surface 11 of the qubit substrate 10, the first angle α is preferably 150 degrees or less, more preferably 145 degrees or less, and still more preferably 140 degrees or less.

In the first embodiment, as illustrated in FIG. 9A, the area S1 of the bottom surface 51 of the first groove 50 is 1/25 times or more and 1/4 times and less the area S2 of the bottom surface 61 of the second groove 60. When the area S1 of the bottom surface 51 of the first groove 50 is 1/25 times or more the area S2 of the bottom surface 61 of the second groove 60, the reliability of the electrical connection between the first conductive film 21 and the second conductive film 22 can be improved. When the area S1 of the bottom surface 51 of the first groove 50 is 1/4 times or less the area S2 of the bottom surface 61 of the second groove 60, the mechanical strength of the first conductive film 21 and the second conductive film 22 can be suppressed from being reduced.

From the viewpoint of reliability of electrical connection, the area S1 of the bottom surface 51 of the first groove 50 is preferably 1/20 times or more, more preferably 1/15 times or more, and still more preferably 1/10 times or more the area S2 of the bottom surface 61 of the second groove 60. From the viewpoint of suppressing the decrease in mechanical strength, the area S1 of the bottom surface 51 of the first groove 50 is preferably 1/5 times or less, more preferably 1/6 times or less, and still more preferably 1/8 times or less the area S2 of the bottom surface 61 of the second groove 60.

In addition, in First embodiment, the thickness of the second conductive film 22 is 50 nm or more and 500 nm or less. In such a case, in the comparative example, the strength of the second conductive film 22 is reduced, and breakage is likely to occur. Therefore, in such a case, it is preferable to use the first embodiment. The thickness of the second conductive film 22 may be 50 nm or more and 300 nm or less.

In the first embodiment, the second groove 60 is formed by using the Bosch process in which the etching process and the protective film forming process are repeated as illustrated in FIG. 4A. As illustrated in FIG. 5C, after the second groove 60 is formed, the Josephson element 31 constituting the qubit 30 is formed on the upper surface 11 of the qubit substrate 10. When the second groove 60 is formed by using the Bosch process, since the scallops are generated on the side surface 62 of the second groove 60, the scallops are removed by an etchant to flatten the side surface 62. By forming the Josephson element 31 after forming the second groove 60, the Josephson element 31 is not affected by the etchant for removing the scallops. Therefore, the characteristic change of the Josephson element 31 can be suppressed. Further, although the temperature rise occurs at the time of forming the second groove 60, the Josephson element 31 is formed after the second groove 60 is formed, whereby the Josephson element 31 is not affected by the temperature rise, and therefore, the change in the characteristics can be suppressed.

In the first embodiment, as illustrated in FIGs. 4A to 6A, the Josephson element 31 constituting the qubit 30 is formed on the upper surface 11 of the qubit substrate 10 after the second groove 60 is formed and before the first groove 50 is formed. By forming the Josephson element 31 before forming the first groove 50, no groove is formed in the upper surface 11 of the qubit substrate 10 when the Josephson element 31 is formed. Therefore, variations in the film thickness of the laminated resist film 72 illustrated in FIGs. 7D to 7F and 8C can be suppressed. Therefore, variations in the width and thickness of the superconducting films 33 and 34 in the Josephson element 31 can be suppressed, and variations in the characteristics of the Josephson element 31 can be suppressed.

In the first embodiment, as illustrated in FIG. 2B, the bottom surface 51 of the first groove 50 is flush with the bottom surface 61 of the second groove 60. This makes it possible to bring the first conductive film 21 and the second conductive film 22 into good contact with each other, and to improve the reliability of the electrical connection. Since the depth D2 of the second groove 60 is larger than the depth D1 of the first groove 50, the diameter L4 (see FIG. 6A) of the first groove 50 can be suppressed from increasing.

### [Second embodiment]

The plan view and the cross-sectional view of the quantum device according to the second embodiment are the same as those of FIGs. 1, 2A, and 2B of the first embodiment, and therefore, illustration and description thereof are omitted.

### [Manufacturing Method]

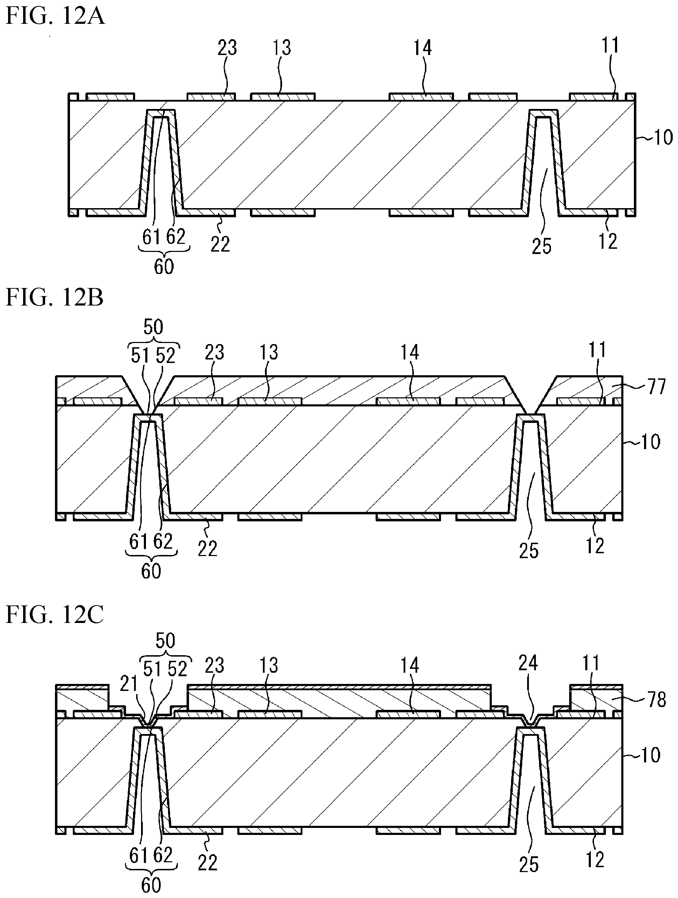

FIGs. 12A to 13B are cross-sectional views illustrating a method of manufacturing a quantum device according to a second embodiment. As illustrated in FIG. 12A, the same steps as those illustrated in FIGs. 4A to 5B in the first embodiment are performed to form the third conductive film 23 on the upper surface 11 of the qubit substrate 10. The second conductive film 22 is formed on the lower surface 12 of the qubit substrate 10 and on the bottom surface 61 and the side surface 62 of the second groove 60.

As illustrated in FIG. 12B, a patterned resist film 77 is formed on the upper surface 11 of the qubit substrate 10. The first groove 50 having the bottom surface 51 and the side surface 52 is formed in the upper surface 11 of the qubit substrate 10 by using the resist film 77 as a mask. The first groove 50 is formed so as to reach only a part of the bottom surface 61 of the second groove 60, as in the first embodiment. As a result, a part of the second conductive film 22 formed on the bottom surface 61 of the second groove 60 is exposed from the bottom surface 51 of the first groove 50. The plan view of the connecting portion between the first groove 50 and the second groove 60 is the same as that of FIG. 9A.

As illustrated in FIG. 12C, after the resist film 77 is removed, a patterned resist film 78 is formed on the upper surface 11 of the qubit substrate 10. The first conductive film 21 is formed by, for example, a vacuum evaporation method by using the resist film 78 as a mask. The first conductive film 21 is formed from the bottom surface 51 and the side surface 52 of the first groove 50 to the upper surface of the third conductive film 23, and is in contact with the third conductive film 23. In the first groove 50, the cavity 24 is formed inside the first conductive film 21. The plan view of the contact portion between the first conductive film 21 and the second conductive film 22 is the same as that illustrated in FIG. 9B.

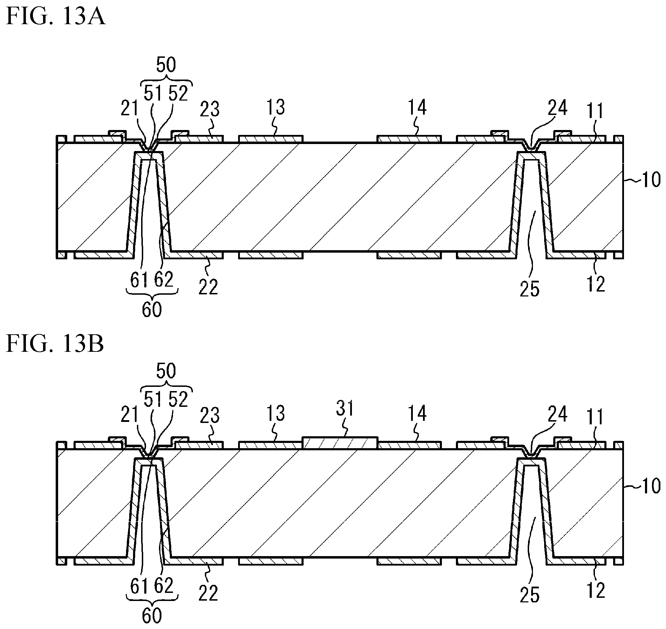

As illustrated in FIG. 13A, the resist film 78 and the first conductive film 21 formed on the resist film 78 are removed by the lift-off method.

As illustrated in FIG. 13B, the Josephson element 31 is formed on the upper surface 11 of the qubit substrate 10, thereby forming the qubit 30 (see FIG. 1). The Josephson element 31 is formed by the same method as the method illustrated in FIGs. 7A to 7I and 8A to 8F. As described above, the quantum device according to the second embodiment is formed.

According to the second embodiment, as illustrated in FIG. 12A, the second groove 60 is formed in the lower surface 12 (second surface) of the qubit substrate 10. The second conductive film 22 is formed on the bottom surface 61 and the side surface 62 of the second groove 60. As illustrated in FIG. 12B, after the second conductive film 22 is formed, the first groove 50 reaching a part of the bottom surface 61 of the second groove 60 is formed in the upper surface 11 (first surface) of the qubit substrate 10. As illustrated in FIG. 12C, the first conductive film 21 is formed on the bottom surface 51 and the side surface 52 of the first groove 50. Since the first groove 50 is formed so as to reach a part of the bottom surface 61 of the second groove 60, the mechanical strength of the first conductive film 21 and the second conductive film 22 can be suppressed from being reduced, as in the first embodiment.

In the second embodiment, as illustrated in FIGs. 12A to 13B, after the second groove 60 and the first groove 50 are formed, the Josephson element 31 constituting the qubit 30 is formed on the upper surface 11 of the qubit substrate 10. Since the Josephson element 31 is formed after the second groove 60 is formed, the Josephson element 31 is not affected by etchant for removing scallops generated in the Bosch process, and the characteristic change of the Josephson element 31 can be suppressed. By forming the Josephson element 31 after the formation of the first groove 50, a resist film or the like is not formed on the Josephson element 31. For example, when the protective film such as the resist film 77 used for forming the first groove 50 and a silicon oxide film between the resist film 77 and the Josephson element 31 is provided, the protective film is not formed on the Josephson element 31. Therefore, the Josephson element 31 is less likely to be damaged. Further, by forming the Josephson element 31 after forming the second groove 60 and the first groove 50, it is possible to suppress a change in the characteristics of the Josephson element 31 with time.

Although the embodiment of the present invention is described in detail, the present invention is not limited to the specifically described embodiments and variations but other embodiments and variations may be made without departing from the scope of the claimed invention.

## Claims

1. A method of manufacturing a quantum device (100) including a qubit (30) and a qubit substrate (10) having a first surface (11) on which the qubit is formed, the method **characterized by** comprising:
forming a first groove (60) in a second surface (12) of the qubit substrate;
forming a first conductive film (22) on a bottom surface (61) and a side surface (62) of the first groove;
forming a second groove (50) reaching a part of the bottom surface of the first groove in the first surface after the forming the first conductive film;
forming a second conductive film (21) on a bottom surface (51) and a side surface (52) of the second groove; and
forming the qubit on the first surface.

2. The method of manufacturing the quantum device according to claim 1, wherein the forming the first groove forms the first groove having a depth larger than a depth of the second groove.

3. The method of manufacturing the quantum device according to claim 1 or 2, wherein
the forming the first groove forms the first groove in which a first angle formed by the side surface of the first groove and the second surface is an obtuse angle, and
the forming the second groove forms the second groove in which a second angle formed by the side surface of the second groove and the first surface is larger than the first angle.

4. The method of manufacturing the quantum device according to claim 1 or 2, wherein
the forming the second groove forms the second groove in which an area of the bottom surface of the second groove is 1/25 times or more and 1/4 times or less an area of the bottom surface of the first groove.

5. The method of manufacturing the quantum device according to claim 1 or 2, wherein
a thickness of the first conductive film is 50 nm or more and 500 nm or less.

6. The method of manufacturing the quantum device according to claim 1, wherein
the forming the first groove forms the first groove by using a Bosch process in which an etching step and a protective film forming step are repeatedly performed, and
the forming the qubit forms the qubit on the first surface after the forming the first groove.

7. The method of manufacturing the quantum device according to claim 1, wherein
the forming the qubit forms the qubit on the first surface after the forming the first groove and before the forming the second groove.

8. The method of manufacturing the quantum device according to claim 1, wherein
the forming the qubit forms the qubit on the first surface after the forming the second groove.

9. The method of manufacturing a quantum device according to any one of claims 6 to 8, wherein
the qubit includes a Josephson element (31).

10. A quantum device (100) **characterized by** comprising:
a qubit substrate (10);
a qubit (30) provided on a first surface (11) of the qubit substrate;
a first groove (60) provided in a second surface (12) of the qubit substrate;
a first conductive film (22) provided on a bottom surface (61) and a side surface (62) of the first groove;
a second groove (50) that is provided in the first surface and reaches a part of the bottom surface of the first groove; and
a second conductive film (21) provided on a bottom surface (51) and a side surface (52) of the second groove.

11. The quantum device according to claim 10, wherein
the bottom surface of the second groove is flush with the bottom surface of the first groove, and
a depth of the first groove is greater than a depth of the second groove.
